## Europäisches Patentamt

## European Patent Office

## Office européen des brevets

(19)

(11) Veröffentlichungsnummer: **0 022 280**
**B1**

(12) **EUROPÄISCHE PATENTSCHRIFT**

(45) Veröffentlichungstag der Patentschrift:
**29.06.83**

(51) Int. Cl.³: **H 01 L 21/308,** H 01 L 21/306, H 01 L 21/316, C 23 F 1/02

(21) Anmeldenummer: **80200482.0**

(22) Anmeldetag: **22.05.80**

(54) **Verfahren zum Ätzen von Silizium-Substraten.**

(30) Priorität: **04.07.79 CH 6230/79**

(43) Veröffentlichungstag der Anmeldung:
**14.01.81 Patentblatt 81/2**

(45) Bekanntmachung des Hinweises auf die Patenterteilung:
**29.06.83 Patentblatt 83/26**

(84) Benannte Vertragsstaaten:
**CH DE FR GB LI NL SE**

(56) Entgegenhaltungen:
**FR-A-1 298 627**
**GB-A-1 281 010**
**US-A-3 355 291**
**US-A-3 432 405**

**RCA Review Band 31, No. 4, Dezember 1970 Princeton N.J. USA, W. KERN et al.: «Deposition and Properties of Silicon Dioxide and Silicate Films Prepared by Low-Temperature Oxidation of Hybrides» Seiten 715–727**

(73) Patentinhaber: **BBC Aktiengesellschaft Brown, Boveri & Cie., Haselstrasse, CH-5401 Baden (CH)**

(72) Erfinder: **Spickenreuther, Dieter, Stiegelenstrasse 15 d, CH-5430 Wettingen (CH)**

## Verfahren zum Ätzen von Silicium-Substraten

Die Erfindung betrifft das Ätzen von Substraten, die im wesentlichen aus elementarem Silicium bestehen oder eine im wesentlichen aus elementarem Silicium bestehende Oberflächenschicht besitzen und hier als Silicium-Substrate bzw. kurz als Si-Substrate bezeichnet werden.

Si-Substrate werden für viele Zwecke der kommerziellen Halbleitertechnik benötigt und müssen häufig im Zuge ihrer Verarbeitung selektiv geätzt werden, worunter hier allgemein das Entfernen von vorbestimmten Teilbereichen der Oberfläche eines Si-Substrates bis zu einer vorbestimmten Tiefe verstanden wird.

Insbesondere wird als Ätzen im engeren Sinne die chemische Behandlung von mit Ätzmasken versehenen Si-Substraten verstanden.

Als Ätzmittel können wegen der amphoteren Eigenschaften von Silicium entweder saure Ätzmittel, z.B. mit Fluorwasserstoff in wässriger Lösung, oder alkalische Ätzmittel, z.B. anorganische Basen, wie KOH, oder organische Basen, wie Ethylendiamin/Brenzkatechin-Lösungen (auch als EDP-Lösungen bezeichnet), verwendet werden.

Zum Abdecken der nicht zu ätzenden Oberflächenbereiche der Si-Substrate werden Schutzschichten bzw. Ätzmasken verwendet, die entweder auf die Substrate aufgetragen werden, wie z.B. Abdecklacke oder aufgedampfte Metallschichten, oder durch lokale chemische Umwandlung, z.B. Oxidieren oder Nitridieren, auf der Si-Oberfläche gebildet werden.

Die Maskenöffnungen können dabei entweder durch selektives Auftragen der Maskenschicht auf die zu maskierenden Bereiche oder durch selektive Entfernung der Maskenschicht von den zu ätzenden Bereichen der Si-Substratoberflächen gebildet werden.

Die Maskenschichten für saure, insbesondere HF enthaltende Ätzmittel werden meist aus Abdecklacken, z.B. Photolacken, auf Basis von organischen Polymeren mit mehr oder weniger hoher Säurebeständigkeit, aber geringer Basenbeständigkeit gebildet, insbesondere wenn nur relativ geringe Ätztiefen hergestellt werden sollen; für alkalische Ätzmittel, wie konzentrierte KOH- oder EDP-Lösungen, werden thermisch aufgewachsene Siliciumoxid- bzw. Siliciumnitridschichten oder aufgedampfte Metallschichten (z.B. Cr-Au) als Maskenschichten verwendet.

Die Anwendbarkeit von Abdecklacken ist dementsprechend auf saure Ätzmittel und vergleichsweise geringe Ätztiefen beschränkt. Die gegen alkalische Ätzmittel beständigen Metallmasken können nur beschränkt verwendet werden, weil die Einführung von Fremdmetallen in der Si-Halbleitertechnologie meist unerwünscht ist, insbesondere wenn auf das Ätzen noch Behandlungsschritte bei erhöhter Temperatur folgen.

Maskenschichten aus thermisch aufgewachsenem Siliciumnitrid haben den Nachteil, dass sie vergleichsweise schwierig zu ätzen sind, besonders wenn genaue Ätzstrukturen gebildet werden sollen; die Nitridierungsbehandlungen sind überdies aufwendig. Maskenschichten aus thermisch aufgewachsenem Siliciumoxid werden von heissen alkalischen Ätzmitteln angegriffen; da der Angriff von alkalischem Ätzmittel auf $SiO_2$ meist erheblich langsamer erfolgt (z.B. bei heisser KOH im Verhältnis 1:200, bezogen auf [100] Silicium), als auf das Si-Substrat, könnte die mangelnde Beständigkeit der Schutzschicht an sich mit Hilfe von entsprechend dicken aufgewachsenen $SiO_2$-Schichten auf der Oberfläche des Si-Substrates ausgeglichen werden. Dieser Massnahme sind jedoch praktische Grenzen dadurch gesetzt, dass das Aufwachsen einer $SiO_2$-Schicht auf dem Si-Substrat relativ langsam vor sich geht. So wären beispielsweise zum Ätzen von Si-Substraten unter den obengenannten Bedingungen (heisse KOH, Si [100]) auf Ätztiefen von 1000 µm Schutzschichten aus aufgewachsenem $SiO_2$ mit Dicken von mindestens etwa 6 µm erforderlich. Zur Bildung solcher Schutzschichten müsste das Si-Substrat aber in der oxidierenden Atmosphäre einige hundert Stunden auf 1100–1200 °C erhitzt werden.

Nun ist es bekannt (IEEE Transactions on Electron Devices, 25, 1978, Seiten 1178–1184 und 1185–1193), dass die Geschwindigkeit des Ätzens (Ätzrate, z.B. in µm Ätztiefe pro Zeiteinheit bei gegebener Temperatur ) von der Kristallografischen Struktur der geätzten Si-Schicht abhängig ist und die Ätzrate in der Folge (100) > (110) > (111) abnimmt. Das oben gegebene Beispiel ist aber diesbezüglich bereits optimiert, so dass das sogenannte anisotrope Ätzen von Silicium mit den bisher verwendeten Ätzmasken jedenfalls dann Schwierigkeiten bereitet, wenn Ätztiefen von mehr als 20 µm erforderlich sind.

Ferner hat man versucht (Literatur siehe oben), die relative Unbeständigkeit von $SiO_2$-Schutzschichten bzw. Masken durch Verwendung von Ätzmitteln zu vermeiden, welche die $SiO_2$-Schutzschicht weniger stark angreifen als Alkalimetallhydroxid, z.B. auf Basis von Ethylendiamin und Brenzkatechin (in der Literatur auch als EDP-Lösungen bezeichnet), gegebenenfalls auch mit Hydrazin, in wässriger Lösung. Nachteilig hierbei ist, dass die Silicium-Ätzrate von der Dotierungskonzentration des Si-Substrates abhängig ist und der Ätzvorgang nur in einer nichtoxidierenden Atmosphäre durchgeführt werden kann.

Aufgabe der Erfindung ist es, ein Verfahren gemäss Oberbegriff von Patentanspruch 1 anzugeben, bei welchem eine auch für Tiefätzungen geeignete und vergleichsweise einfach aufzutragende Ätzmaske verwendet wird. Diese Aufgabe wird erfindungsgemäss dadurch gelöst, dass als Ätzmaske eine auf der Oberfläche des Substrates haftende Schicht aus mineralischem Glas verwendet wird, vorzugsweise mit Schichtdicken, die im Vergleich zu thermisch aufgewachsenen $SiO_2$-Schichten relativ dick sind und typisch Dicken von 1–10 µm, vorzugsweise 5–20 µm haben.

Die Verwendung von Glasmasken auf Siliciumsubstraten ist zur selektiven anodischen Oxidation aus US-A-3 432 405 an sich bekannt; hierbei ist das Glas aber keinem Angriff durch Ätzmittel ausgesetzt.

Bekannt ist ferner aus FR-A-1 298 627 die Verwendung von Schutzschichten aus Glas in der Halbleiterfertigung, wobei zum Passivieren der Seitenflächen von mechanisch zerteilten Halbleiterschichtungen durch Abbeizen der Seitenflächen aufgekittete Glasschichten auf den Ober- und Unterseiten der Stapel verwendet werden, um den Zutritt des Beizmittels zu Ober- und Unterseiten der Stapel zu verhindern.

Die Eignung mineralischer Glasschichten als Ätzmasken für das Ätzen von Siliciumsubstraten ist überraschend, weil Mineralglasschichten als unbeständig gegen alkalische Ätzmittel gelten und gegen solche Mittel jedenfalls nicht beständiger sind als thermisch aufgewachsene $SiO_2$-Schichten.

Im Gegensatz zu diesen können Mineralglasschichten aber ohne besondere Probleme, z.B. nach den aus der oben genannten US-A-3 432 405 bekannten Methoden, in ausreichender Dicke aufgetragen werden, um die vergleichsweise schlechte Beständigkeit von Mineralglasschichten gegen typische Ätzmittel für Silicium durch entsprechend höhere Schichtdicken mindestens auszugleichen.

So können nach dem erfindungsgemässen Verfahren beispielsweise die aus GB-A-1 281 010 bekannten Ätzmittel verwendet werden. Zum Abätzen der Glasmaske kann in der beispielsweise aus RCA-Review, Dezember 1970, Seite 724, bekannten Weise eine wässrige HF-Lösung verwendet werden.

Für viele Anwendungen des erfindungsgemässen Ätzverfahrens ist die Verwendung von praktisch alkalimetallfreiem Mineralglas aus den z.B. in US-A-3 432 405 genannten Gründen zweckmässig.

Maskenschichten für das erfindungsgemässe Verfahren können unter Verwendung von Mischungen hergestellt werden, wie sie z.B. aus US-PS 3 355 291 bekannt sind, und die fotopolymerisationsfähiges Bindemittel enthalten. Dies wird weiter unten eingehender erläutert.

Es versteht sich, dass die Mineralglasschicht auch zum Flächenschutz der Si-Substrate verwendet und dort, wenn erforderlich, in vergleichsweise grösserer Dicke aufgebaut werden kann.

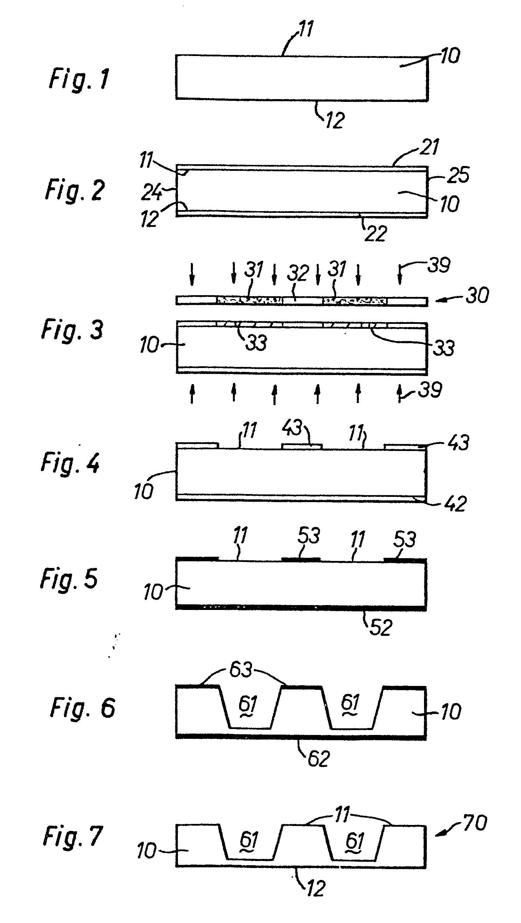

Die Erfindung wird anhand der Zeichnungen erläutert. Die Fig. 1–8 veranschaulichen in schematischer Darstellung die Stufen eines Ausführungsbeispiels des erfindungsgemässen Verfahrens.

Fig. 1 zeigt das Si-Substrat 10, z.B. eine Si-Scheibe, die vollständig oder mindestens in der die Oberfläche 11 bildenden Teilschicht aus Si besteht. Die Unterfläche 12 soll in diesem Beispiel nicht geätzt werden, doch fallen auch beidseitige Ätzungen, d.h. auf beiden Flächen 11, 12, unter die Erfindung. Wenn das Substrat 10 bzw. dessen zu ätzende Fläche 11 monokristallin ist, liegt die Fläche 11 vorzugsweise in der (100)-Ebene.

Fig. 2 zeigt das auf beiden Aussenflächen 11, 12 mit den Schichten 21, 22 versehene Si-Substrat. Die Schichten 21, 22 sind nicht notwendigerweise gleich dick, und die untere Schicht 22 kann z.B. erheblich dicker sein als die obere Schicht 21. Beide Schichten 21, 22 enthalten feinteiliges Silikatglaspulver und ein thermisch (z.B. bei Temperaturen über 400 °C) entfernbares Bindemittel. In der oberen Schicht 21 besteht das Bindemittel mindestens teilweise aus üblichem Photolack. Die untere Schicht 22 kann Photolack enthalten, was im vorliegenden Beispiel der Fall ist. Die Seitenflächen 24, 25 können ebenfalls mit solchen Schichten bedeckt oder auf andere Weise geschützt sein.

Gemäss Fig. 3 wird auf die obere Schicht 21 des Si-Substrates 10 eine Photomaske 30 mit opaken Bereichen 31 und transparenten Bereichen 32 aufgelegt. Dann wird das Substrat 10 von beiden Seiten mit aktinischer Strahlung, z.B. UV- oder Tageslicht je nach Empfindlichkeit des Photolakkes, bildmässig belichtet. Dadurch polymerisiert der Photolack in der gesamten Schicht 22 und in den durch die transparenten Bereiche der Photomaske 30 bestimmten Bereichen der oberen Schicht 21. In den unbelichteten Bereichen 33 der Schicht 21 bleibt der Photolack unverändert.

Fig. 4 zeigt das Substrat 10 mit einer durch «Entwickeln» bzw. «Fixieren» verbleibend gemachten unteren Schicht 42 und den verbleibenden Maskenbereichen 43 der fixierten oberen Schicht 41. Durch Entfernen der unbelichteten Bereiche 33 von Fig. 3 ist die Oberfläche 11 des Substrates bereichsweise freigelegt.

Fig. 5 zeigt das Substrat 10 nach dem Erhitzen des mit den verbliebenen Schichtbereichen 42, 43 in Fig. 4 dargestellten Substrates 10 auf Temperaturen im Bereich von 400 bis 1100 °C derart, dass Schichten bzw. Schichtbereiche 52, 53 aus Glas durch Verschmelzen der Glasteilchen der Schichten bzw. Schichtbereiche 42, 43 gebildet und die darin enthaltenen organischen Bindemittelanteile entfernt bzw. zersetzt worden sind. Die Schicht 53 hat z.B. eine Dicke von 5–10 µm; die Schicht 52 ist mindestens ebenso dick wie die Schicht 53.

Nunmehr werden die in Fig. 5 freiliegenden Substratflächenbereiche 11, d.h. die Ätzfenster, der Einwirkung von Ätzmittel, z.B. wässriger 50%iger KOH-Lösung bei 80 °C, ausgesetzt, was nach etwa 15 Std. die in Fig. 6 dargestellte Form des mit den Ausätzungen 61, 62 (Ätztiefe ca. 900 µm) versehenen Substrates 10 ergibt, das die durch Abätzung dünner gewordenen, aber immer noch wirksamen Reste 62, 63 der Glasschichten 52, 53 trägt. Diese restlichen Teile 62, 63 der Ätzmaske bzw. Schutzschicht aus Glas werden nunmehr entfernt, z.B. durch Abätzen mit HF, was das in Fig. 7 dargestellte fertig geätzte Gebilde 70 aus dem Substrat 10 liefert.

Wie oben angedeutet, werden als Mineralgläser meist Silikatgläser bevorzugt, wozu hier auch Aluminiumsilikat-, Alumoborsilikat-, Bleialumosilikat, Bleisilikat-, Borsilikatgläser und dergleichen mit unterschiedlichen Anteilen typischer Glaszusätze gehören. Spezielle Beispiele für Silikatgläser sind in der Tabelle I zusammengestellt. Aber auch Gläser mit einem anderen Gerüst als dem Silikatgerüst einschliesslich von praktisch silikatfreien Mineralgläsern (weniger als 5% $SiO_2$), wie Borat-, Aluminiumborat-, Phosphat- und Aluminiumphosphatgläser kommen in Betracht, zumal solche Mineralgläser unter Umständen gegen HFenthaltende, nichtalkalische Ätzmittel beständig sind, wie z.B. Spezialgläser auf Basis von $Sb_3O_4$/$Al_2O_3$/Alkali.

Von den Silikatgläsern sind als allgemeine Beispiele die sogenannten Normalgläser, Gerätegläser, Thüringerglas, Bleigläser, Borgläser, einschliesslich der unter verschiedenen Markenbezeichnungen, wie PYREX, SCHOTT, JENAER, DURAN, OSRAM, CORNING, INNOTECH usw., von den Firmen gleichen Namens und anderen, wie St. Gobain, Schübel, Putzler, Fischer, Gerresheim, Gundelach, Libbey usw., erhältlichen Gläser zu nennen.

Die Erweichungs- bzw. Verarbeitungstemperaturen erfindungsgemäss geeigneter Mineralgläser liegen zwischen etwa 400 und 1200 °C, z.B. zwischen 500 und 1100 °C; die Mohshärte kann typisch zwischen 4 und 8, die Zugfestigkeit zwischen 3,5 und 8,5, der Elastizitätsmodul zwischen 4000 und 10 000 kg/mm² und der lineare Wärmeausdehnungskoeffizient zwischen 35 und 110 liegen. Abweichungen von den eben genannten Werten sind jedoch möglich; überdies ist für die Wahl geeigneter Gläser die chemische Zusammensetzung in dem Sinne zu berücksichtigen, dass das Glas im allgemeinen praktisch frei von Elementen sein sollte, die beim erfindungsgemässen Verfahren in das Si-Substrat eindiffundieren und dadurch nachteilige Effekte, z.B. ungewollte Dotierungen, auslösen können. So ist z.B. für viele Zwecke der Halbleitertechnologie das unkontrollierte Eindiffundieren von Alkalimetallen, insbesondere Na, K, zu vermeiden, und man wird in einem solchen Fall entsprechend alkalimetallfreie Mineralgläser bzw. Silikatgläser, wie Jenaer Geräteglas (Schott), IP 820 ($SiO_2$/PbO/$Al_2O_3$) der Firma Innotech bzw. analoge alkalifreie Produkte anderer Lieferanten, verwenden. Jedenfalls ist die Wahl geeigneter Mineralglaszusammensetzungen für das erfindungsgemässe Verfahren eine fachmännische Massnahme.

Als Beispiel für eine bevorzugte Gruppe geeigneter Silikatgläser sind solche zu nennen, die als Hauptbestandteil 40–70 Gew.-% $SiO_2$, 0–25 Gew.-% $B_2O_3$, 0–50 Gew.-% PbO und 0–10 Gew.-% $Al_2O_3$ in glasbildenden Anteilen enthalten. Bevorzugte Mineralgläser haben einen Sinter- bzw. Glasbildungsbereich von 400–900 und bilden bei Temperaturen von 600–1100 °C Schmelzen.

Die Verwendung von feinteiligem (z.B. 1–100 µm) Glas in den Schichten 21, 22 wird bevorzugt, doch können auch entsprechend zusammengesetzte glasbildende Mischungen der gewählten anorganischen Oxide mit Bindemittel bzw. Photolack vermischt werden.

Tabelle 1
Techn. Silikatgläser (Zusammensetzung in Gew.-%)

| $SiO_2$ | $B_2O_3$ | PbO | $Al_2O_3$ | ZnO | BaO | CaO | $Na_2O$ | $K_2O$ | MgO | sonstige (Oxid) | Bemerkungen |
|---|---|---|---|---|---|---|---|---|---|---|---|
| 68 | | | 3,5 | | | 7,5 | 12 | 7,5 | 0,5 | | norm. «Schübel» |
| 53 | | 33 | | | | | | 14 | | | norm. K/Ca/Pb |
| 71 | | | | | | 11 | | 18 | | | norm. K/Ca |
| 78 | | | 0,3 | | | 5 | 7 | 10 | | | norm. K/Ca |
| 75,5 | | | | | | 11,6 | 12,9 | | | $0,2\ Fe_2O_3$ | norm. Na/Ca |
| 77 | | | 0,2 | | | 8 | 12 | 3 | | $0,2\ Fe_2O_3$ | norm. Na/Ca |
| 80,8 | 12 | | 2,3 | | | 0,3 | 4,7 | 0,1 | | $0,2\ Fe_2O_3 + 0,2\ As_2O_3$ | «PYREX» |
| 67,5–73 | 0–10 | | 2,5–10 | 0–7 | | 0,4–7 | 10–14 | 0–0,1 | 0–0,2 | | «JENAER» Jenaer App. |
| 65 | 15 | 31 | 3,5 | | 12 | | 4 | 9 | | | Bleiglas |
| 56 | 16 | | 0,2 | | | | 5 | 1 | | | «DURAN» |
| 76 | 21 | | 2 | | | | 9 | 0,5 | | | indiff. |
| 65 | 22 | | 4 | | | | 6,5 | — | | | indiff. |
| 67 | | | 2 | | | | | | | | |
| 42 | | 50 | | | 0,3 | 0,3 | 2 | 4 | | | «R-51» |

Allgemein sollten die Teilchen aus Glas bzw. Glasbildner maximale Teilchengrössen $T_g$ haben, die kleiner als oder höchstens gleich wie die Dicke $D_g$ der Schichten 21, 22 sind. Eine breite Verteilung der Teilchengrösse im genannten Bereich kann jedoch vorteilhaft sein, um eine hohe Packungsdichte zu erzielen.

Eine zum Beschichten von Si-Substraten 10 mit Ätzmasken- bzw. Schutzschichten 21, 22 geeignete Zubereitung kann z.B. durch Herstellung einer Suspension von feinteiligem Glas in einem geeigneten Bindemittel hergestellt und durch Aufspachteln, Aufstreichen, Aufsprühen, Aufspinnen oder dergleichen Methoden auf die Si-Substrate aufgebracht werden. Dann kann das Bindemittel, z.B. durch Verdampfen oder Veraschen, entfernt und das Substrat durch Erhitzen unter Aufschmelzen des Glases mit fest anhaftenden, durchgehenden kompakten Schutzschichten aus mineralischem Glas versehen werden. Die gewünschte Maskenstruktur kann auf an sich üblichem Wege photolithographisch mit HF enthaltender Ätzlösung zur selektiven Entfernung der Schutzschicht aus Glas erhalten und dann wie im Zusammenhang mit den Fig. 5 und 6 erläutert zur Ätzung des Si-Substrates behandelt werden.

Bindemittel, die durch aktinische Strahlung polymerisiert («gehärtet») werden können, stellen unter anderem aus Gründen der vereinfachten Erzeugung der Maskenstruktur und jedenfalls der Vereinfachung des Verfahrens eine bevorzugte Ausführungsform der Erfindung dar. Si-Substrate mit einer gegen aktinische Strahlung empfindlichen Schicht, die zur Glasbildung durch Erhitzen befähigt ist, stellen eine besondere Ausführungsform der Erfindung dar.

Photopolymerisierbare Massen bzw. Lösungen sind als solche in der Druckerei(Lichtsatz)- bzw. Ätztechnik bekannt und technisch von verschiedenen Firmen (z.B. E.I. Du Pont de Nemours, BASF, usw.) erhältlich. Photolacke bzw. Photoresistmaterialien sind Beispiele für geeignete Zubereitungen.

Das erfindungsgemässe Verfahren bzw. das erfindungsgemässe Si-Substrat kann auf allen Gebieten der Herstellung bzw. Verarbeitung von Si-Substraten, d.h. insbesondere in der Halbleitertechnologie angewendet werden. Die Herstellung von Si-Diaphragmen bzw. die technische Fertigung von druckempfindlichen Sensoren (siehe z.B. B. K. D. Wise et al, «Diaphragm Formation and Pressure Sensitivity in Batch-fabricated Silicon Pressure Sensors», University of Michigan, Ann Arbor, USA) ist als bevorzugtes Anwendungsbeispiel zu nennen.

Die Erfindung wird anhand des folgenden Ausführungsbeispiels unter Bezugnahme auf die Beschreibung zu den Fig. 1–7 weiter erläutert:

Als Si-Substrat 10 (Fig. 1) diente eine monokristalline Si-Scheibe mit 25,4 mm Durchmesser und 1 mm Dicke mit (100)-Orientierung. Eine Mischung aus feinteiligem (5 µm) Glas «IP 820» ($SiO_2$/PbO/$Al_2O_3$, hochreine Qualität) der Firma Innotech Glas Products wurde mit technischem Photolack «SC-Photoresist» (Firma Waycoat) zu einer noch fliessfähigen Masse vermischt und mit einer üblichen Lackschleuder (Spinner) auf beiden Oberflächen 11, 12 der Scheibe 10 bei 4000 U/min verteilt. Dabei wurden auch die Seitenflächen 24, 25 der Scheibe bedeckt.

Die so aufgetragenen Photolack-Glaspulverschichten wurden 15 min bei 80 °C vorgehärtet, dann in üblicher Weise durch eine Maske 30 auf der Oberfläche der Schicht 21, aber frei von allen anderen Seiten belichtet und dann entwickelt. Dadurch wurde die Beschichtung in den Bereichen 33 entsprechend den Maskenfenstern entfernt. Die zurückbleibenden Schichtteile 42, 43 sowie die Beschichtungen der Flächen 24, 25 wurden nun 20 min bei 120 °C nachgehärtet und dann 5 min in einem Ofen unter Luftzutritt auf 500 °C erhitzt. Dadurch wurden die organischen Schichtkomponenten verbrannt, so dass auf den abgedeckten Bereichen des Substrates 10 eine anhaftende dünne, 5–10 µm starke Glaspulverschicht zurückblieb, die dann durch 15 min Erhitzen auf ca. 900 °C zu fest an den abzudeckenden Bereichen des Si-Substrates 10 haftenden Glasschichten 52, 53 verschmolzen wurde.

Das so mit Schutzschicht bzw. Maske versehene Substrat 10 wurde während 15 Std. in 50gewichtsprozentiger wässriger KOH bei ca. 80 °C geätzt, wodurch eine Ätztiefe der Ätzstellen 61 von 850–900 µm erzielt und die verbleibenden Schutzschichten 62, 63 zwar dünner als die Glasschichten 52, 53 waren, das Substrat 10 aber immer noch ausreichend gegen das Ätzmittel schützten, d.h. es war trotz einer erheblichen Ätztiefe kein Verlust der Maskierfähigkeit aufgetreten.

Die auf diese Weise erhaltenen geätzten Si-Substrate 70 waren zur Verwendung als Druckmembranen und gelochte Trägerplatten für Drucksensoren geeignet.

Es versteht sich, dass im Rahmen der Erfindung zahlreiche Modifikationen der oben zum Ätzen von Si-Substraten erfindungsgemäss als Schutzschichten bzw. Ätzmasken verwendeten Mineralglasschichten möglich sind, z.B. Verwendung anderer Glassorten, Bindemittel, Ätzmittel und dergleichen.

## Patentansprüche

1. Verfahren zur selektiven Ätzung eines praktisch aus elementarem Silicium bestehenden Substrates (10) durch Auftragen einer temporären Ätzmaske (53) auf mindestens eine zu ätzende Oberfläche (11) des Substrates (10), Behandeln mit einem Ätzmittel zur Entfernung von Silicium aus den nicht von der Ätzmaske (53) bedeckten Teilen der Oberfläche (11) des Substrates (10) unter Bildung von Ätzstellen (61) und nachfolgende Entfernung der Ätzmaske (53), dadurch gekennzeichnet, dass als Ätzmaske (53) eine auf der Oberfläche (11) des Substrates (10) haftende Schicht (53) aus mineralischem Glas verwendet wird.

2. Verfahren nach Patentanspruch 1, dadurch gekennzeichnet, dass als mineralisches Glas ein Silikatglas verwendet, das Substrat (10) mit einem alkalischen Ätzmittel, vorzugsweise einem wässrigen Ätzmittel, geätzt und die Ätzmaske (53) nach dem Ätzen durch Fluorwasserstoff, vorzugsweise wässriger HF-Lösung, entfernt wird.

3. Verfahren nach Patentanspruch 1 oder 2, dadurch gekennzeichnet, dass das mineralische Glas praktisch frei von Alkalimetallen ist.

4. Verfahren nach einem der Patentansprüche 1–3, dadurch gekennzeichnet, dass die Ätzmaske (53) durch Auftragen einer Mischung, die feinteiliges mineralisches Glas und Bindemittel oder eine zur Bildung von mineralischem Glas bei Erhitzen befähigte Zusammensetzung enthält, auf das Substrat (10) und Erhitzen der Mischung zur Bildung einer auf dem Substrat (10) haftenden Schicht (53) aus mineralischem Glas gebildet wird.

5. Verfahren nach Patentanspruch 4, dadurch gekennzeichnet, dass die Mischung feinteiliges mineralisches Glas, vorzugsweise mit Teilchengrössen von 1 bis 100 µm, sowie eine durch aktinische Strahlung polymerisationsfähige Komponente enthält, dass die auf das Substrat (10) schichtförmig aufgetragene Mischung bildmässig mit aktinischer Strahlung belichtet, zur Entfernung der schichtförmigen Mischung (33) von den zu ätzenden Bereichen der Oberfläche (11) des Substrates (10) behandelt und die auf dem Substrat (10) verbliebene Mischung (43) zur Bildung der Ätzmaske (53) aus mineralischem Glas erhitzt wird.

6. Verfahren nach einem der Patentansprüche 1–5, dadurch gekennzeichnet, dass der Ätzmaskenbereich (53) der Schutzschicht (52, 53) aus mineralischem Glas mit einer Schichtdicke von 1 bis 100 µm, vorzugsweise 5 bis 20 µm, gebildet wird.

7. Verfahren nach Patentanspruch 6, dadurch gekennzeichnet, dass das Substrat (10) bereichsweise (12) zum flächenhaften Schutz gegen das Ätzmittel mit einer Schicht (52) aus mineralischem Glas versehen wird, die eine grössere Dicke hat als die Schicht (53) im Bereich zwischen benachbarten Fenstern der Ätzmaske.

8. Verfahren nach einem der Patentansprüche 1–7, dadurch gekennzeichnet, dass als Ätzmittel eine Lösung verwendet wird, die eine anorganische Base, vorzugsweise KOH oder NaOH, oder eine organische Base, vorzugsweise Ethylendiamin und Brenzkatechin, enthält.

9. Anwendung des Verfahrens nach Patentanspruch 1 zur Herstellung von Drucksensoren, die ein bereichsweise geätztes Silicium-Substrat enthalten.

**Claims**

1. Process for selectively etching a substrate (10) consisting virtually of elementary silicon by applying a temporary etching mask (53) to at least one surface (11), to be etched, of the substrate (10), treating with an etch to remove silicon from those parts of the surface (11) of the substrate (10) which are not covered by the etching mask (53), etched areas (61) being formed, and subsequently removing the etching mask (53), characterised in that a layer (53) of mineral glass adhering to the surface (11) of the substrate (10) is used as the etching mask (53).

2. Process according to Patent Claim 1, characterised in that the mineral glass used is a silicate glass, the substrate (10) is etched with an outer line etch, preferably an aqueous etch, and the etching mask (53) is removed after etching by means of hydrogen fluoride, preferably an aqueous HF solution.

3. Process according to Patent Claim 1 or 2, characterised in that the mineral glass is virtually free of alkali metals.

4. Process according to one of Patent Claims 1–3, characterised in that the etching mask (53) is formed by applying a mixture, which contains finely particulate mineral glass and a binder or a composition capable of forming mineral glass on heating, to the substrate (10) and heating the mixture to form a mineral glass layer (53) adhering to the substrate (10).

5. Process according to Patent Claim 4, characterised in that the mixture contains finely particulate mineral glass, preferably having particle sizes of 1 to 100 µm, and a component capable of polymerisation by means of actinic radiation, that the mixture applied in the form of layers to the substrate (10) is exposed image-wise to actinic radiation and is treated for removal of the layer-type mixture (33) from those areas of the surface (11) of the substrate (10) which are to be etched, and the mixture (43) remaining on the substrate (10) is heated to form the etching mask (53) of mineral glass.

6. Process according to one of Patent Claims 1–5, characterised in that the etching mask area (53) of the protective layer (52, 53) of mineral glass is formed with a layer thickness of 1 to 100 µm, preferably 5–20 µm.

7. Process according to Patent Claim 6, characterised in that the substrate (10), for area-wise protection against the etch, is provided zonally (12) with a mineral glass layer (52) which has a greater thickness than the layer (53) in the zone between neighbouring windows of the etching mask.

8. Process according to one of Patent Claims 1–7, characterised in that the etch used is a solution which contains an inorganic base, preferably KOH or NaOH, or an organic base, preferably ethylenediamine and pyrocatechol.

9. Use of the process according to Patent Claim 1 for the manufacture of pressure sensors which contain a zonally etched silicon substrate.

**Revendications**

1. Procédé d'attaque chimique sélective d'un substrat (10) consistant pratiquement en silicium élémentaire par application d'un masque de morsure temporaire (53) sur au moins une surface à attaquer (11) du substrat (10), par traitement au moyen d'un agent d'attaque en vue de l'élimination du silicium des parties de la surface (11) du substrat (10) qui ne sont pas couvertes par le masque de morsure (53) avec formation de régions d'attaque (61) et ensuite par élimination du masque de morsure (53), caractérisé en ce qu'on utilise comme masque de morsure (53), une couche (53) en verre minéral adhérant à la surface (11) du substrat (10).

2. Procédé suivant la revendication 1, caractérisé en ce qu'on utilise comme verre minéral, un verre de silicate, on attaque le substrat (10) au moyen d'un agent d'attaque alcalin, de préférence un agent d'attaque aqueux et on élimine le masque de morsure (53), après l'attaque au moyen d'acide fluorhydrique de préférence une solution aqueuse de HF.

3. Procédé suivant la revendication 1 ou 2, caractérisé en ce que le verre minéral est pratiquement exempt de métaux alcalins.

4. Procédé suivant l'une quelconque des revendications 1 à 3, caractérisé en ce que le masque de morsure (53) est formé par application d'un mélange qui contient un verre minéral finement divisé et un liant ou une composition propre à former un verre minéral par chauffage sur le substrat (10) et par chauffage du mélange pour la formation d'une couche (53) en verre minéral adhérant sur le substrat (10).

5. Procédé suivant la revendication 4, caractérisé en ce que le mélange contient du verre minéral finement divisé, de préférence d'une granulométrie de 1 à 100 µm, ainsi qu'un composant polymérisable par un rayonnement actinique, on expose au rayonnement actinique en conformité avec une image le mélange appliqué en couche sur le substrat (10), on traite le mélange en vue de l'élimination du mélange en forme de couche (33) des régions attaquées de la surface (11) du substrat (10) et on chauffe le mélange (43) restant sur le substrat (10) pour la formation d'un masque de morsure (53) en verre minéral.

6. Procédé suivant l'une quelconque des revendications 1 à 5, caractérisé en ce que le domaine du masque de morsure (53) de la couche de protection (52, 53) est formé par du verre minéral d'une épaisseur de couche de 1 à 100 µm et de préférence de 5 à 20 µm.

7. Procédé suivant la revendication 6, caractérisé en ce que le substrat (10) est muni dans des régions (12) en vue de la protection latérale contre l'agent d'attaque, d'une couche (52) de verre minéral qui présente et plus grande épaisseur que la couche (53) dans le domaine entre les fenêtres contiguës du masque de morsure.

8. Procédé suivant l'une quelconque des revendications 1 à 7, caractérisé en ce qu'on utilise comme agent d'attaque une solution qui contient une base inorganique, de préférence NaOH ou KOH ou une base organique, de préférence l'éthylènediamine et la pyrocatéchine.

9. Procédé suivant la revendication 1 de fabrication de capteurs de pression qui contiennent un substrat en silicium attaqué localement.

Fig. 1

Fig. 2

Fig. 3

Fig. 4

Fig. 5

Fig. 6

Fig. 7